# EUROPEAN PATENT APPLICATION

(11) **EP 4 376 564 A1**
(43) Date of publication of application: **29.05.2024**
(21) Application number: 22845236.3
(22) Date of filing: 15.07.2022
(51) Int. Cl.: H05K 7/20

(54) **CONNECTOR HAVING SEMICONDUCTOR COOLING DEVICE, AND AUTOMOBILE**

(30) Priority: 20.07.2021 CN 202110821575
(71) Applicant: Changchun Jetty Automotive Technology Co., Ltd., Changchun City, Jilin Province 130000 (CN)
(72) Inventor: WANG, Chao, Changchun, Jilin 130000 (CN)
(74) Representative: Habermann, Hruschka & Schnabel
(86) International application number: PCT/CN2022/105980
(87) International publication number: WO 2023/001071

(57) **Abstract**

The present disclosure provides a connector having a semiconductor cooling device, and an automobile. The connector includes a lead wire (22), a terminal (23) and a semiconductor cooling device (30). One end of the terminal (23) is connected to the lead wire (22), and the other end thereof is used to be connected to an external electrical structure. The semiconductor cooling device (30) includes a refrigeration portion (31) that absorbs heat of the terminal and a heat dissipation portion (32). The present disclosure mitigates the technical problems of high heat generation at a connection point between the lead wire and the terminal and frequent burnout of the connection point.

## Description

### RELATED APPLICATION

The present disclosure claims priority to Chinese Invention Patent Application No. CN202110821575.X, filed on July 20, 2021, and entitled "CONNECTOR HAVING SEMICONDUCTOR COOLING DEVICE, AND AUTOMOBILE".

### TECHNICAL FIELD

The present disclosure relates to the technical field of electrical devices, in particular to a connector having a semiconductor cooling device, and an automobile.

### BACKGROUND

The current required for automobile to start up is relatively high, and can be as high as 150A to 250A, which has high requirements for current-carrying capacity of lead wires and connectors. The working current and charging current of electric vehicles are also high, which also has high requirements for the current-carrying capacity of lead wires and connectors. The lead wire usually has a set rated current, and its heat generation is stable. The delivery of current can be realized by using a lead wire whose rated current meets the requirement.

However, the contact resistance at a connection point between the lead wire and a terminal is high. As a result, the voltage drop between the terminal and the lead wire is large, thus the heat generated at the connection point between the lead wire and the terminal is generally high, which results in frequent burnout of the connection point, and may lead to major safety incidents.

Therefore, there is an urgent need in the technical field of electrical devices for a connector that can mitigate the technical problems of high heat generation at the connection point of the lead wire and the terminal, and frequent burnout of the connection point.

### SUMMARY

An objective of the present disclosure is to provide a connector having a semiconductor cooling device and an automobile, to mitigate the technical problems of high heat generation at a connection point between a lead wire and a terminal and frequent burnout of the connection point.

The objective of the present disclosure can be achieved by the following technical solutions.

The present disclosure provides a connector having a semiconductor cooling device, and the connector includes a lead wire, a terminal and a semiconductor cooling device. One end of the terminal is connected to the lead wire, and the other end thereof is used to be connected to an external electrical structure. The semiconductor cooling device includes a refrigeration portion that absorbs heat of the terminal and includes a heat dissipation portion.

The present disclosure provides an automobile including the above-described connector having the semiconductor cooling device.

The present disclosure has features and advantages as follows:

The external electrical structure is connected to the connector having the semiconductor cooling device through the terminal, and is electrically connected to the lead wire, to realize the transmission of electric energy. Due to a high contact resistance that usually exists between the external electrical structure and the terminal, heat will be continuously generated in the connected state. In the connector, the semiconductor cooling device is electrically connected to the lead wire, and can obtain electric energy from the lead wire and starts to operate, during which heat is transferred from the refrigeration portion to the heat dissipation portion, and is dissipated from the heat dissipation portion to the outside, so that the temperature of the refrigeration portion gradually decreases, thus the refrigeration portion can absorb heat from the terminal, to make the terminal and the external electrical structure maintain a safe and stable temperature, thereby realizing stable temperature control, and reducing safety accidents such as burnout of the connection point. The connector can be used to solve the problem of over-high temperature at the connection point when the charging current of electric vehicles is high, and can help to realize fast charging of charging harnesses of electric vehicles with high current.

In the connector, the semiconductor cooling device is used to cool the terminal, no refrigerant is used, and no kinematic mechanism is included, so that extra vibration and noise can be avoided, and the connector is safe and stable and has a long service life. The current in the lead wire can be shunted in the connector to power the semiconductor cooling device, so there is no need for an additional power supply device and no need to provide or replace a power storage box, so that the connector is convenient and durable, and facilitates realizing continuous operation and reducing maintenance man-hours.

### BRIEF DESCRIPTION OF DRAWINGS

The drawings below are only intended to schematically illustrate and explain the present disclosure, and do not limit the scope of the present disclosure. In the drawings:
FIG. 1 is a structural schematic diagram of a connector having a semiconductor cooling device according to an embodiment of the present disclosure;
FIG. 2 is a structural schematic diagram of a connector having a semiconductor cooling device according to another embodiment of the present disclosure;
FIGS. 3 and 4 are cross-sectional views of a connector having a semiconductor cooling device provided according to the present disclosure;
FIGS. 5-8 are structural schematic diagrams of a connector having a semiconductor cooling device according to still another embodiment of the present disclosure;
FIGS. 9-17 are schematic diagrams of a terminal and a lead wire in a connector having a semiconductor cooling device according to the present disclosure;
FIGS. 18-20 are structural schematic diagrams of a connector having a semiconductor cooling device according to yet still another embodiment of the present disclosure; and
FIG. 21 is a structural diagram of a semiconductor cooling device in a connector having a semiconductor cooling device according to the present disclosure.

### DESCRIPTION OF EMBODIMENTS

For a clearer understanding of the technical features, objectives and effects of the present disclosure, specific embodiments will now be described with reference to the drawings. In the description of the present disclosure, 'a plurality of' means two or more unless otherwise specified.

### First Embodiment

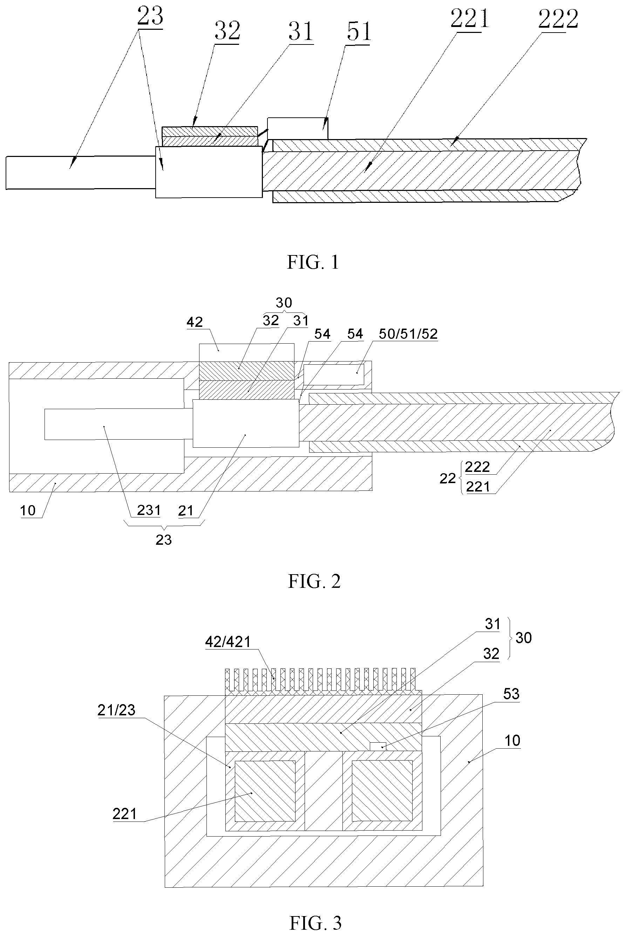

The present disclosure provides a connector having a semiconductor cooling device, as illustrated in FIG. 1, the connector includes a lead wire 22, a terminal 23 and a semiconductor cooling device 30. The lead wire 22 is connected to the terminal 23. The terminal 23 is used to be connected to an external electrical structure. The semiconductor cooling device 30 includes a refrigeration portion 31 and a heat dissipation portion 32. The refrigeration portion 31 absorbs heat from the terminal 23. The semiconductor cooling device 30 is electrically connected to the lead wire 22.

Specifically, the semiconductor cooling device 30 is in principle a tool for heat transfer. When a piece of N-type semiconductor material and a piece of P-type semiconductor material are coupled to form a thermocouple pair through which a current passes, heat transfer may occur between two ends, i.e., the heat may be transferred from one end to the other end, thereby generating a temperature difference to form a hot end and a cooling end. The semiconductor cooling device 30 described herein includes a hot end and a cooling end that are arranged opposite to each other. The semiconductor cooling device 30 can be a semiconductor cooling device existing in the prior art, and can also be customized according to the size of the conductor.

The external electrical structure is connected to the connector through the terminal 23, and is electrically connected to the lead wire 22 through the terminal 23, so as to realize the transmission of electric energy. Due to a high contact resistance that usually exists between the external electrical structure and the terminal 23, heat will be continuously generated in the connected state. In the connector, the semiconductor cooling device 30 is electrically connected to the lead wire 22, and can obtain electric energy from the lead wire 22. When the semiconductor cooling device 30 is in operation, heat is transferred from the refrigeration portion 31 to the heat dissipation portion 32, and is dissipated from the heat dissipation portion 32 to the outside, so that the temperature of the refrigeration portion 31 gradually decreases, thus the refrigeration portion 31 can absorb heat from the terminal 23, to make the terminal 23 and the external electrical structure maintain a safe and stable temperature, thereby realizing stable temperature control, and reducing safety accidents such as burnout of the connection point. The use of the connector can solve the problem of high temperature at the connection point when the charging current of electric vehicles is high, thereby contributing to realizing fast charging of charging harnesses of electric vehicles with high current.

In the connector, the semiconductor cooling device 30 is used to cool the terminal 23, without using a refrigerant and without including a kinematic mechanism, so that extra vibration and noise can be avoided, and the connector is safe and stable and has a long service life. In the connector, a shunt of the current in the lead wire 22 can be used to power the semiconductor cooling device 30, so there is no need for an additional power supply device and no need to provide or replace a power storage box, so that the connector is convenient and durable, and facilitates realizing continuous operation and reducing maintenance man-hours.

In an embodiment, as illustrated in FIG. 2, the connector further includes a protective structure device 10, and the terminal 23 is disposed in the protective structure device 10. In some high-current environments, the terminal 23 needs to be insulated, so the protective structure device 10 is arranged on a periphery of the terminal 23 to realize an insulation of the terminal 23 from an external environment. In addition, when there are a large number of terminals 23 to be connected to the external electrical structure, if the terminals 23 are plugged to the external electrical structure one by one, the operation is complicated and time-consuming. Therefore, in this embodiment, the terminals 23 are placed at intervals in the protective structure device 10, so only one operation of plugging the protective structure device 10 to the external electrical structure is needed to realize the one-to-one plugging of the terminals 23 to the external electrical structure, which is simple to operate and makes it less likely to cause incorrect plugging of the terminals, thereby ensuring correctness and safety of the circuit. The protective structure device 10 may be a sheath.

In an embodiment, the connector comprises a rectifier 51. One end of the rectifier 51 is electrically connected to the semiconductor cooling device 30 through a connecting wire 54, and the other end of the rectifier 51 is electrically connected to the lead wire 22 through the connecting wire 54. The rectifier 51 may be electrically connected to a connecting portion 21 through the connecting wire 54, and thus electrically connected to the lead wire 22. The current of the lead wire 22 is shunted to supply power to the semiconductor cooling device 30. The current and voltage supplied to the semiconductor cooling device 30 are regulated by the rectifier 51 to be compatible with the working current and voltage of the semiconductor cooling device 30, so as to ensure stable operation of the semiconductor cooling device 30.

Further, a control unit 50 of the connector includes a controller 52. The controller 52 is connected to the rectifier 51 and is configured to regulate a current flowing through the rectifier 51 toward the semiconductor cooling device 30. The controller 52 regulates the current of the semiconductor cooling device 30, so as to adjust the temperature of the refrigeration portion 31 of the semiconductor cooling device 30, thereby adjusting the temperature of the connecting portion 21. Specifically, one end of the rectifier 51 is electrically connected to the lead wire 22, and the other end of the rectifier 51 is electrically connected to the controller 52 and the semiconductor cooling device 30, respectively, so as to supply power to the controller 52 and the semiconductor cooling device 30.

As illustrated in FIG. 3, the connector includes a temperature sensor 53 connected to the controller 52. The temperature sensor 53 is in contact connection with the terminal 23, and/or in contact connection with the refrigeration portion 31. The temperature sensor 53 is configured to detect the temperature of the connector, and transmit a temperature signal to the controller 52. The controller 52 is configured to control the rectifier 51 to regulate the current supplied to the semiconductor cooling device 30 according to the detected temperature, so as to adjust the temperature of the refrigeration portion 31 of the semiconductor cooling device 30, thereby guaranteeing a stable operating temperature of the connecting portion 21. For example, when the temperature is detected to be increased, the controller 52 controls the rectifier 51 to increase the supply current, so as to speed up the efficiency of the semiconductor cooling device 30 in dissipating heat to the outside; and when the temperature is detected to be decreased, the controller 52 controls the rectifier 51 to reduce the supply current, so as to slow down the efficiency of the semiconductor cooling device 30 in dissipating heat to the outside. The temperature sensor 53, the controller 52 and the rectifier 51 are cooperated to regulate the current of the semiconductor cooling device 30, so as to realize a constant temperature of the connector and avoid a temperature change of the connector due to a change in current of the lead wire 22. Exemplarily, the temperature sensor 53 is in contact connection with the connecting portion 21, and the temperature sensor 53 is configured to detect the temperature of the connecting portion 21.

The controller 52 may be a mechanical controller. The mechanical controller includes at least two alloy sheets with different temperature expansion coefficients. The alloy sheets bend and deform when temperature changes to drive contacts to close and open, thereby realizing power on and off of the mechanical controller. Alternatively, the controller 52 may be an electronic controller. The electronic controller receives an electrical signal from the temperature sensor 53, and analyzes the electrical signal by a chip, to control the power on and off of the semiconductor cooling device 30.

The rectifier 51 rectifies an unstable high current in the lead wire 22 into a stable small current that can be used by the controller 52 and the temperature sensor 53 through a combination of resistors, diodes and other electronic components, so as to realize a constant and stable power supply.

The temperature sensor 53 may be a contact temperature sensor, specifically may be a bimetallic thermometer, a pressure thermometer, a resistance thermometer, a thermistor or a thermocouple. The temperature sensor 53 can convert a real-time temperature of the connecting portion 21 or the refrigeration portion 31 into an electrical signal, and transmit the electrical signal to the controller 52.

In an embodiment, there are a plurality of semiconductor cooling devices 30. In order to accurately control the temperature of each semiconductor cooling devices 30, the plurality of semiconductor cooling devices 30 are connected in parallel and electrically connected to the rectifier 51, so that the current supplied to each semiconductor cooling device 30 can be individually controlled.

Further, when the plurality of semiconductor cooling devices 30 have the same model and the same power, the plurality of semiconductor cooling devices 30 are connected in series and electrically connected to the rectifier 51, so that the current supplied to each semiconductor cooling device 30 is the same.

Further, the semiconductor cooling device 30 is embedded in a side wall of the protective structure device 10, the refrigeration portion 31 is located inside the side wall of the protective structure device 10, and at least a portion of a surface of the heat dissipation portion 32 is exposed outside the protective structure device 10, thereby facilitating the refrigeration portion 31 of the semiconductor cooling device 30 to absorb heat from the terminal 23 and dissipate the heat to the outside through the heat dissipation portion 32.

In an embodiment, the heat from the terminal 23 is transferred to the refrigeration portion 31 by radiant heat transfer. In another embodiment, the refrigeration portion 31 is connected to the terminal 23 to absorb heat from the terminal.

As illustrated in FIGS. 2-5, the refrigeration portion 31 is in contact connection with the terminal 23, which facilitates the heat from the terminal 23 to be quickly transferred to the refrigeration portion 31, so that the heat can be dissipated to the outside in time, the heat generated by the terminal 23 can be adequately taken away, and the temperature can be reduced to achieve the purpose of rapid cooling.

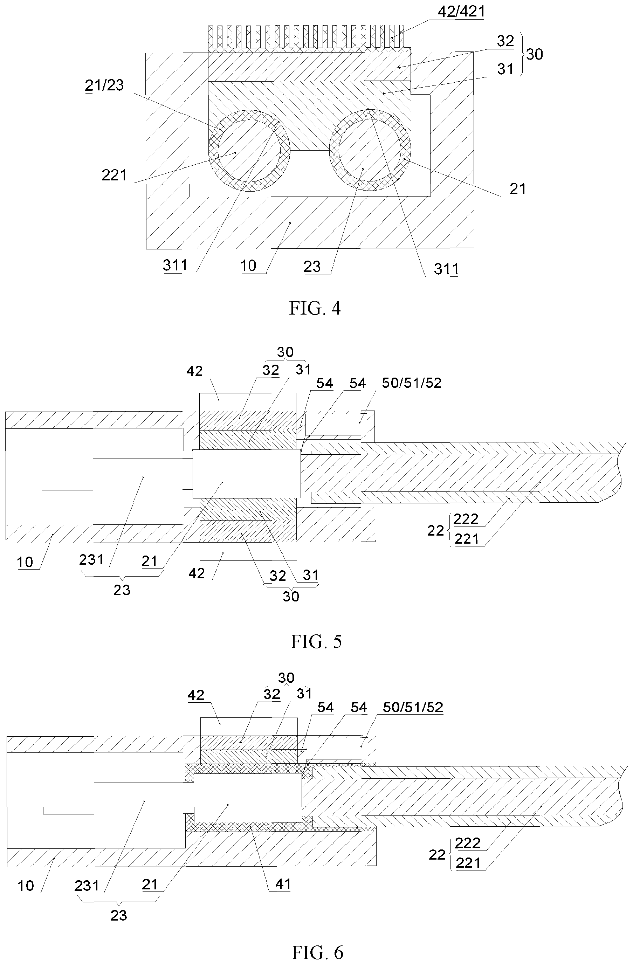

Further, the refrigeration portion 31 is provided with an accommodating groove 311, and at least part of the terminal 23 is embedded in the accommodating groove 311. The shape of the accommodating groove 311 is adapted to the shape of an outer contour of the terminal 23, and the terminal 23 is in contact with an inner wall of the accommodating groove 311, so that the refrigeration portion 31 and the terminal 23 are kept in close contact with each other, thereby increasing the contact area therebetween, and facilitating the transfer of heat from the terminal 23 to the refrigeration portion 31. Exemplarily, as illustrated in FIG. 4, the accommodating groove 311 is semi-cylindrical in shape.

As illustrated in FIGS. 6, 7 and 18, the connector includes a heat conductive member 41 being in contact connection with both the terminal 23 and the refrigeration portion 31, so that the heat from the connecting portion 21 is transferred to the refrigeration portion 31 through the heat conductive member 41. By providing the heat conductive member 41, it is beneficial for the terminal 23, the heat conductive member 41 and the refrigeration portion 31 to be kept in close contact with each other in sequence, so that the heat generated by the terminal 23 is quickly transferred to the refrigeration portion 31, thereby reducing the temperature, improving the heat dissipation performance, achieving the purpose of rapid cooling, and ensuring a constant temperature of the terminal 23. The heat conductive member 41 may be made of a thermally conductive and electrically non-conductive material. The heat conductive member 41 may be formed by filling a thermally conductive and electrically non-conductive material between the terminal 23 and the refrigeration portion 31. The heat conductive member 41 may be made of one or more selected from the group consisting of thermally conductive silicone grease, thermally conductive mica sheet, thermally conductive ceramic sheet, and thermally conductive silicone sheet.

Further, the heat conductive member 41 surrounds the terminal 23, and the refrigeration portion 31 is in contact with the terminal 23 through the heat conductive member 41. The heat conductive member 41 may be set in a cylindrical shape to conveniently absorb heat generated at different positions of the terminal 23. In some cases, the connector includes a plurality of terminals 23. A plurality of heat conductive members 41 may be provided respectively and are sleeved outside the plurality of terminals 23 in a one-to-one correspondence, and the plurality of heat conductive members 41 are all in contact connection with the refrigeration portion 31 of one semiconductor cooling device 30. Alternatively, one heat conductive member 41 is provided to surround the plurality of terminals 23, and the heat from the plurality of terminals 23 is transferred to the refrigeration portion 31 through the heat conductive member 41.

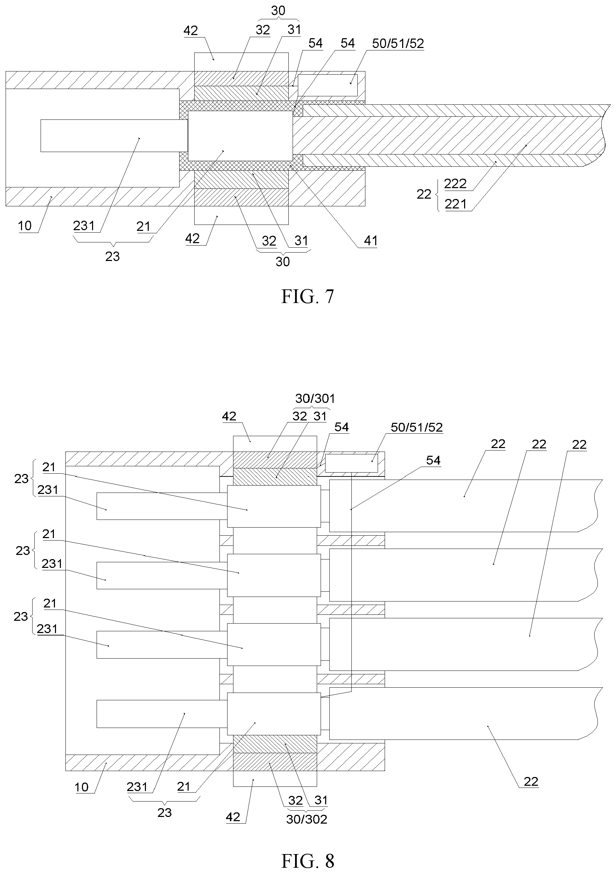

In an embodiment of the present disclosure, the connector includes at least two semiconductor cooling devices 30, and the at least two semiconductor cooling devices 30 are distributed on two sides of the terminal 23 to absorb heat from the two sides of the terminal 23, thereby improving the cooling efficiency. As illustrated in FIGS. 5 and 7, two semiconductor cooling devices 30 may be distributed on two opposite sides of the terminal 23.

As illustrated in FIG. 8, the connector includes a plurality of terminals 23, and the connecting portion 21 of each terminal 23 is connected to the lead wire 22, respectively. The connector includes a plurality of semiconductor cooling devices 30, and the plurality of semiconductor cooling devices 30 includes a first cooling device 301 and a second cooling device 302. The first cooling device 301, the plurality of connecting portions 21 and the second cooling device 302 are distributed in sequence. In an embodiment, the plurality of terminals 23 are sequentially distributed in a left-right direction, the first cooling device 301 is disposed at a left end, and the second cooling device 302 is disposed at a right end. Further, upper and lower sides of the terminals 23 are provided with the semiconductor cooling device 30, respectively.

In an embodiment, the refrigeration portion 31 is provided with an accommodating hole 312, and the terminal 23 is penetrated through the accommodating hole 312. The terminal 23 is accommodated by the accommodating hole 312 to realize a contact connection between the refrigeration portion 31 and the terminal 23, which improves the spatial arrangement of the terminal 23 and the lead wire 22, increases the contact area, and facilitates the heat transfer from the terminal 23 to the refrigeration portion 31, especially in a case where the connector includes a plurality of terminals 23 and lead wires 22, it facilitates an arrangement in a small space and ensures the heat dissipation of each terminal 23.

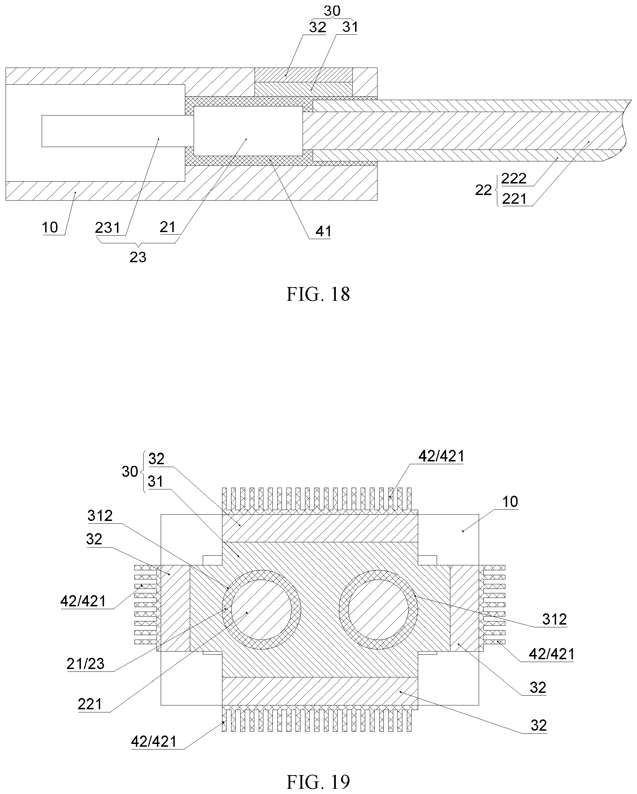

Further, the semiconductor cooling device 30 includes a plurality of heat dissipation portions 32 distributed around the refrigeration portion 31, which facilitates heat dissipation to the outside. As illustrated in FIG. 19, the refrigeration portion 31 is provided with a plurality of accommodating holes 312, the connector includes a plurality of terminals 23, and the terminals 23 are penetrated through the accommodating holes 312 on a one-to-one basis. Exemplarily, the refrigeration portion 31 is in a square shape as a whole, and the heat dissipation portions 32 are distributed on four sides of the refrigeration portion 31.

In an embodiment, the refrigerating portion 31 is provided with a plurality of the accommodating holes 312, the connector includes a plurality of the terminals 23, and the terminals 23 are penetrated through the accommodating holes 312 on a one-to-one basis. As illustrated in FIG 19, the terminals 23 are penetrated within the refrigeration portion 31, and the heat dissipation portions 32 are sleeved outside the refrigeration portion 31, which is conducive to an adequate contact between the refrigeration portion 31 and the terminals 23, and promotes the heat from the terminal 23 to be efficiently transferred to the refrigeration portion 32 through the refrigeration portion 31, improves the compactness of the structure and facilitates the arrangement of the plurality of terminals 23 and the semiconductor cooling devices 30.

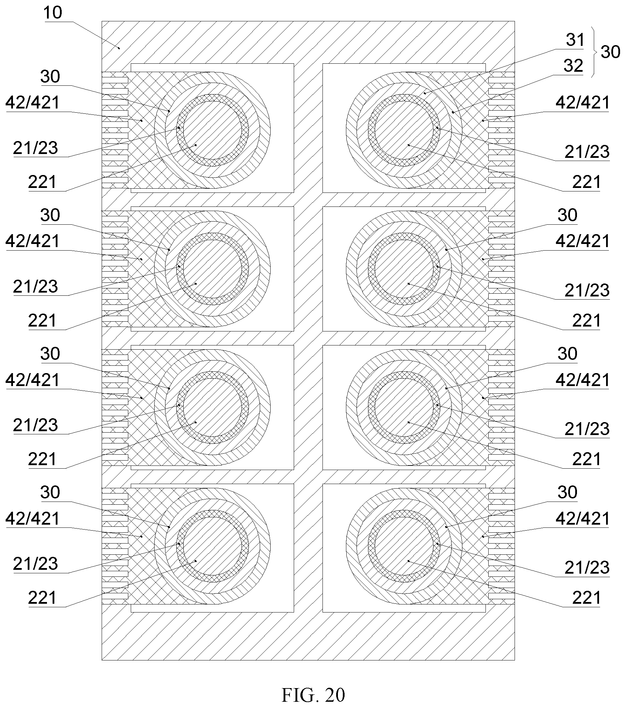

In an embodiment, both the refrigeration portion 31 and the heat dissipation portion 32 are cylindrical in shape, as illustrated in FIG. 20, the terminals 23 are penetrated within the refrigeration portion 31, and the heat dissipation portions 32 are sleeved outside the refrigeration portion 31. Both the cylindrical refrigeration portion 31 and heat dissipation portion 32 are easy to process, have a large contact area therebetween, and achieve an easier transfer of the heat from the terminal 23 to the heat dissipation portion. Further, both the refrigeration portion 31 and the heat dissipation portion 32 are circular cylindrical in shape.

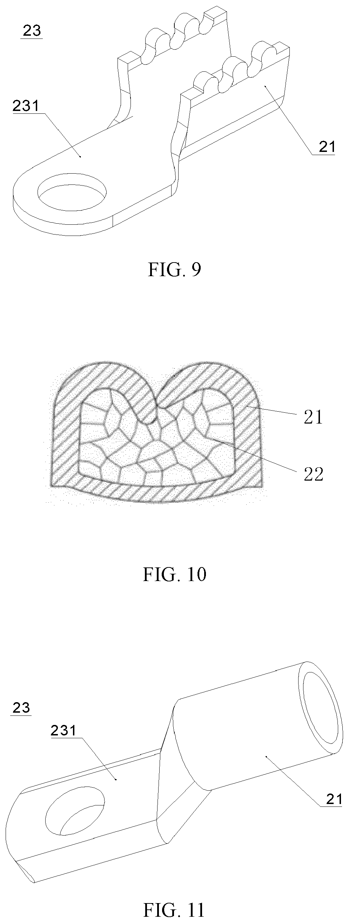

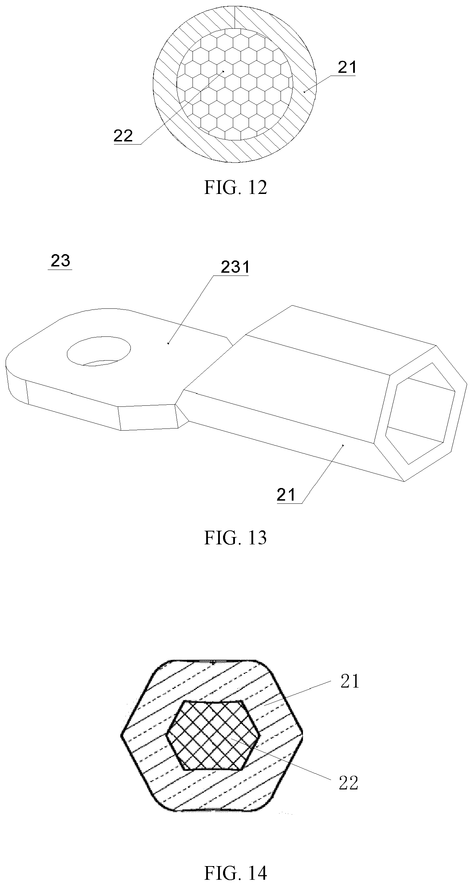

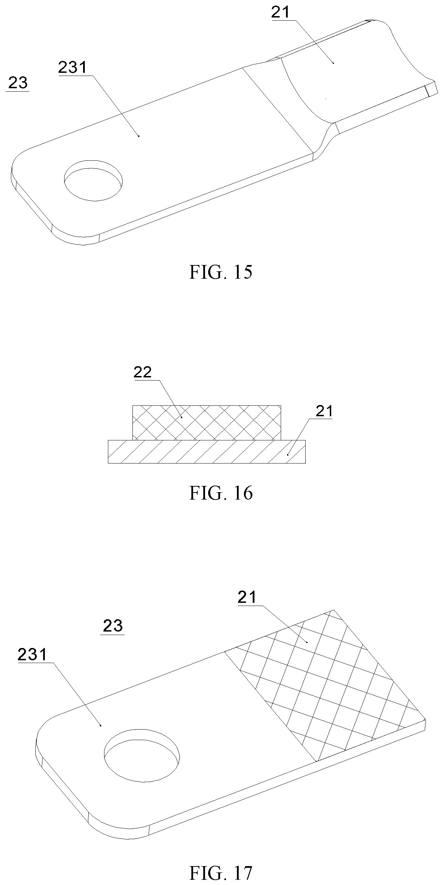

In an embodiment, the terminal 23 is provided with a terminal portion 231 for being connected to an external electrical structure, and a connecting portion 21 used to be connected to the lead wire 22. The connecting portion 21 is not limited to one shape. For example, as illustrated in FIG. 9, an initial shape of the connecting portion 21 is U-shaped, which has a U-shaped groove, and the lead wire 22 is arranged in the U-shaped groove; as illustrated in FIG. 10, side walls of the U-shaped groove are bent inward to compress the lead wire 22, so as to connect the terminal 23 to the lead wire 22. As illustrated in FIGS. 11-14, the connecting portion 21 may be a cylinder, and the lead wire 22 is arranged in the hole of the cylinder. As illustrated in FIGS. 15-17, the connecting portion 21 may be in a shape of a plate, and the lead wire 22 is arranged on one side of the connecting portion 21. A fixed connection between the lead wire 22 and the connecting portion 21 may be achieved by welding or crimping. The terminal portion 231 and the connecting portion 21 may be of one-piece structure, or they may be of separate structures and may be fixed together by welding. Exemplarily, a position of the terminal 23 that is connected to the refrigeration portion 31 is the connecting portion 21, which facilitates the refrigeration portion 31 to absorb heat from the terminal 23.

Further, a contact area between the refrigeration portion 31 and the connecting portion 21 accounts for at least 3% of a surface area of the connecting portion 21 to ensure the heat absorption efficiency.

In order to verify the influence of a range of ratios of the contact area between the refrigeration portion 31 and the connecting portion 21 to the surface area of the connecting portion 21 on a temperature rise of the terminal 23, the inventor adopted 11 groups of lead wires 22 with the same cross-sectional area, the same material and the same length, adopted the same terminals 23, applied the same current, and used different ratios of the contact area between the refrigeration portion 31 and the connecting portion 21 to the surface area of the connecting portion 21. Temperature rise values are read and recorded in Table 1.

The experimental method is to conduct the same current in connectors with different ratios of the contact area between the refrigeration portion 31 and the connecting portion 21 to the surface area of the connecting portion 21 in a closed environment, and record a temperature before the current is applied and a stable temperature during current conduction, and make a difference between the two temperatures to take an absolute value. In this embodiment, a temperature rise value of less than 50K is a qualified value.

**Table 1: Influence of a ratio of the contact area between the refrigeration portion 31 and the connecting portion 21 to the surface area of the connecting portion 21 on a temperature rise of the connector**

| Ratios of the contact area between the refrigeration portion 31 and the connecting portion 21 to the surface area of the connecting portion 21 (%) | | | | | | | | | | | | |
|---|---|---|---|---|---|---|---|---|---|---|---|---|
| 1 | 3 | 5 | 10 | 20 | 30 | 40 | 50 | 60 | 70 | 80 | 90 | 100 |

| Temperature rise values of the connector (k) | | | | | | | | | | | | |
|---|---|---|---|---|---|---|---|---|---|---|---|---|
| 53.6 | 49.6 | 48.8 | 46.2 | 44.3 | 42.5 | 40.7 | 35.7 | 31.2 | 26.7 | 18.2 | 16.6 | 14.9 |

As can be seen from Table 1, when the contact area between the refrigeration portion 31 and the connecting portion 21 accounts for less than 3% of the surface area of the connecting portion 21, the temperature rise value of the connector is less than the qualified value. The larger the proportion of coverage area, the smaller the temperature rise value. Therefore, the inventor set the ratio of the contact area between the refrigeration portion 31 and the connecting portion 21 to the surface area of the connecting portion 21 to be not less than 3%.

The lead wire 22 includes an internal conductor 221 and an insulating layer 222 wrapping the conductor 221, and an end of the conductor 221 is connected to the terminal 23. The semiconductor cooling device 30 is fixed to the protective structure device 10, with the refrigeration portion 31 facing inward and the heat dissipation portion 32 facing outward, and a surface of the refrigeration portion 31 is arranged on a surface of the protective structure device 10 or outside the protective structure device 10. The external electrical structure may be a harness cable or terminal adapted to the terminal 23.

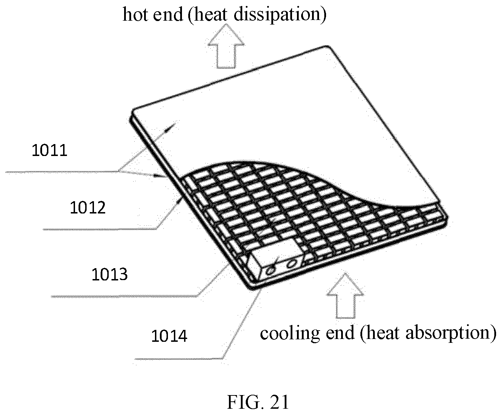

In an embodiment of the present disclosure, as illustrated in FIG. 21, the semiconductor cooling device 30 includes an alumina substrate 1011, a waterproof protection layer 1012, a semiconductor PIN layer 1013, and a power interface 1014.

The alumina substrate 1011, the waterproof protection layer 1012, and the semiconductor PIN layer 1013 are arranged in sequence. The power interface 1014 is electrically connected to the semiconductor PIN layer 1013.

The alumina substrate 1011 serves as a hot end of the semiconductor cooling device 30, i.e., the heat dissipation portion 32. The semiconductor PIN layer 1013 serves as a cooling end of the semiconductor cooling device 30, i.e., the refrigeration portion 31.

In this embodiment, the alumina substrate 1011, used as a surface of the semiconductor cooling device 30, can improve the thermal conductivity, increase the speed of heat transfer, shorten the cooling time, increase the withstandable strength, allow for flexible connection, achieve a better adhesion to the conductor and effectively absorb surface stress at an elbow of the conductor, and is unbreakable during mounting and use. The core of the semiconductor cooling device 30 is a PN junction constituted by special semiconductors. When a piece of N-type semiconductor and a piece of P-type semiconductor are coupled into a thermocouple pair through which a current passes, a heat transfer between two ends occurs, i.e., the heat is transferred from one end to the other end, thereby generating a temperature difference to form a hot end and a cooling end, that is, cooling control can be realized by controlling the DC current.

In an embodiment of the present disclosure, a cooling rate of the semiconductor cooling device 30 is 0.05K/s to 5K/s.

In order to verify the influence of the cooling rate of the semiconductor cooling device 30 on the temperature rise of the connector, the inventor adopted 10 lead wires 22 with the same cross-sectional area, the same material and the same length, adopted the same terminals 23, applied the same current, and used the semiconductor cooling devices 30 with different cooling rates to cool the connector. Temperature rise values are read and recorded in Table 2.

**Table 2: Influence of semiconductor cooling device 30 with different cooling rates on the temperature rise of the connector**

| Cooling rates of the semiconductor cooling device 30 (K/s) | | | | | | | | | | | | |
|---|---|---|---|---|---|---|---|---|---|---|---|---|
| 0.01 | 0.03 | 0.05 | 0.1 | 0.3 | 0.5 | 1 | 2 | 3 | 4 | 5 | 6 | 7 |

| Temperature rise values of the connector (k) | | | | | | | | | | | | |
|---|---|---|---|---|---|---|---|---|---|---|---|---|
| 63.7 | 52.5 | 49.6 | 47.5 | 45.2 | 43.5 | 41.3 | 37.1 | 33.2 | 30.7 | 27.5 | 26.8 | 26.2 |

The experimental method is to conduct the same current in connectors having the semiconductor cooling devices 30 with different cooling rates in a closed environment, and record a temperature before the current is applied and a stable temperature during current conduction, and make a difference between the two temperatures to take an absolute value. In this embodiment, a temperature rise value of less than 50K is a qualified value.

As can be seen from Table 2, when the cooling rate of the semiconductor cooling device 30 is less than 0.05K/s, the temperature rise value of the connector is less than the qualified value, and the greater the cooling rate of the semiconductor cooling device 30, the smaller the temperature rise value. However, when the cooling rate of the semiconductor cooling device 30 is greater than 5K/s, the temperature rise value is not significantly reduced due to the influence of the heat generated by the connector itself and the power of the semiconductor cooling device 30 itself, but the power of the semiconductor cooling device 30 is increased, which is not economical. Therefore, the inventor set the cooling rate of the semiconductor cooling device 30 to 0.05K/s-5K/s.

In an embodiment of the present disclosure, the connector includes a heat dissipation device 42 connected to the heat dissipation portion 32, so as to improve the heat dissipation effect, facilitate the heat from the heat dissipation portion 32 of the semiconductor cooling device 30 to be dissipated to the outside, and ensure rapid cooling. Specifically, the heat dissipation device 42 may be a fan or a heat exchanger or a liquid cooling device. As illustrated in FIGS. 3 and 4, the heat dissipation device 42 may also be cooling fins 421, and the cooling fins 421 are exemplarily made of metal.

The connector has the following advantages: (1) short cooling time, when the temperature of the connecting portion 21 rises, the temperature of the connecting portion 21 can be reduced in a short period of time; (2) the temperature of the connector can be stably controlled, so as to prevent overload-induced burnout of the connection point and reduce safety accidents; (3) since the temperature of the connection point is reduced, it is possible to design the cable without increasing the cable diameter, and it is possible to design the cable to have a cable diameter corresponding to a rated heating curve, without the need to consider increasing the cable diameter to reduce the resistance of the connecting portion, thereby reducing the cable diameter and the cost of the cable; (4) by using the connector, it is possible to solve the problem of over-high temperature at the connection point when the charging current of electric vehicle is high, and it helps to realize fast charging of the charging wire harness of electric vehicle with high current; and (5) the heat dissipation portion 32 of the semiconductor cooling device 30 can be connected to other parts that need to be heated, thereby improving energy utilization.

### Second Embodiment

The present disclosure provides an automobile including the above-described connector having the semiconductor cooling device. The connector in the automobile has the above-described structure, function and advantageous effects, which will not be repeated herein.

Those described above are only the schematic embodiments of the present disclosure, rather than limitations thereto. For those skilled in the art, any equivalent variation and amendment made without departing from the concept and principle of the present disclosure shall fall within the scope of the present disclosure.

## Claims

1. A connector having a semiconductor cooling device, wherein the connector comprises:
a lead wire;
a terminal, one end of which is connected to the lead wire, and the other end of which is used to be connected to an external electrical structure; and
a semiconductor cooling device comprising a refrigeration portion that absorbs heat from the terminal, and a heat dissipation portion.

2. The connector according to claim 1, wherein the semiconductor cooling device is electrically connected to the lead wire.

3. The connector according to claim 1, wherein the connector comprises a protective structure device, and the terminal is disposed in the protective structure device.

4. The connector according to claim 1, wherein the connector comprises a rectifier, one end of which is electrically connected to the semiconductor cooling device, and the other end of which is electrically connected to the lead wire.

5. The connector according to claim 4, wherein the connector comprises a controller connected to the rectifier, and the controller is configured to regulate a current flowing through the rectifier toward the semiconductor cooling device.

6. The connector according to claim 5, wherein the connector comprises a temperature sensor connected to the controller; and
the temperature sensor is in contact connection with the terminal, and/or the temperature sensor is in contact connection with the refrigeration portion.

7. The connector according to claim 4, wherein the connector comprises a plurality of semiconductor cooling devices, and the plurality of semiconductor cooling devices are electrically connected to the rectifier.

8. The connector according to claim 3, wherein the semiconductor cooling device is embedded in a side wall of the protective structure device, the refrigeration portion is located inside the side wall of the protective structure device, and at least a portion of a surface of the heat dissipation portion is exposed outside the protective structure device.

9. The connector according to claim 1, wherein the refrigeration portion is in contact connection with the terminal.

10. The connector according to claim 1, wherein the heat from the terminal is transferred to the refrigeration portion by radiant heat transfer.

11. The connector according to claim 9, wherein the refrigeration portion is provided with an accommodating groove, and at least part of the terminal is embedded in the accommodating groove.

12. The connector according to claim 1, wherein the connector comprises a heat conductive member being in contact connection with the terminal, and the refrigeration portion is in contact connection with the heat conductive member; and
the heat conductive member is made of one or more selected from the group consisting of thermally conductive silicone grease, thermally conductive mica sheet, thermally conductive ceramic sheet, and thermally conductive silicone sheet.

13. The connector according to claim 12, wherein the heat conductive member surrounds the terminal.

14. The connector according to claim 1, wherein the connector comprises at least two semiconductor cooling devices, and the at least two semiconductor cooling devices are distributed on two sides of the terminal.

15. The connector according to claim 1, wherein the refrigeration portion is provided with an accommodating hole, and the terminal is penetrated through the accommodating hole.

16. The connector according to claim 1, wherein the semiconductor cooling device comprises a plurality of heat dissipation portions distributed around the refrigeration portion.

17. The connector according to claim 15, wherein the refrigeration portion is provided with a plurality of accommodating holes; and
the connector comprises a plurality of terminals that are penetrated through the accommodating holes on a one-to-one basis.

18. The connector according to claim 1, wherein both the refrigeration portion and the heat dissipation portion are cylindrical in shape, the terminal is penetrated within the refrigeration portion, and the heat dissipation portion is sleeved outside the refrigeration portion.

19. The connector according to claim 18, wherein both the refrigeration portion and the heat dissipation portion are circular cylindrical in shape.

20. The connector according to claim 1, wherein the terminal comprises a terminal portion, and a connecting portion for being connected to the lead wire; and the refrigeration portion is connected to the connecting portion.

21. The connector according to claim 20, wherein a contact area between the refrigeration portion and the connecting portion accounts is not less than 3% of a surface area of the connecting portion.

22. The connector according to claim 1, wherein the semiconductor cooling device comprises an alumina substrate, a waterproof protection layer, a semiconductor PIN layer, and a power interface;
the alumina substrate, the waterproof protection layer, and the semiconductor PIN layer are arranged in sequence; and
the power interface is electrically connected to the semiconductor PIN layer.

23. The connector according to claim 22, wherein a cooling rate of the semiconductor cooling device is 0.05K/s-5K/s.

24. The connector according to claim 1, wherein the connector comprises a heat dissipation device connected to the heat dissipation portion.

25. An automobile comprising the connector having a semiconductor cooling device according to any one of claims 1 to 24.
